# EUROPÄISCHE PATENTSCHRIFT

(11) **EP 4 088 316 B1**
(45) Veröffentlichungstag und Bekanntmachung des Hinweises auf die Patenterteilung: **26.06.2024**
(21) Anmeldenummer: 20817249.4
(22) Anmeldetag: 30.11.2020
(51) Int. Cl.: H01L 23/427, F28D 15/02, H05K 7/20, H01L 23/367, H01L 23/467, F28F 1/12

(54) **KÜHLVORRICHTUNG**
COOLING DEVICE
DISPOSITIF DE REFROIDISSEMENT

(30) Priorität: 08.01.2020 DE 102020200110
(43) Veröffentlichungstag der Anmeldung: 16.11.2022
(73) Patentinhaber: Robert Bosch GmbH, 70442 Stuttgart (DE)
(72) Erfinder: LORENZ, Marco, 71254 Ditzingen (DE); DOERR, Aaron, 71083 Herrenberg (DE)
(86) Internationale Anmeldenummer: PCT/EP2020/083911
(87) Internationale Veröffentlichungsnummer: WO 2021/139924

(56) Entgegenhaltungen:
- EP-A1- 3 153 808
- EP-A1- 3 203 512
- EP-A2- 0 751 365
- CN-A- 101 533 810
- CN-A- 110 455 106
- CN-Y- 201 218 681
- JP-A- 2002 206 881

## Beschreibung

### Stand der Technik

Die vorliegende Erfindung betrifft eine Kühlvorrichtung zum Kühlen von Bauteilen und eine Elektronikanordnung.

Üblicherweise führen Leistungshalbleiter in der Leistungselektronik hohe Ströme, welche zu einer hohen Verlustwärme führen können. Häufig ist eine Kühlung solcher Leistungshalbleiter erforderlich, beispielsweise zur Vermeidung von Schäden durch Überhitzen. Üblicherweise wird hierfür eine Flüssigkeitskühlung oder eine Luftkühlung verwendet.

Kühlvorrichtungen sind beispielsweise in der EP 3 153 808 A1, der JP 2002 206881 A oder der EP 3 203 512 A1 gezeigt.

### Offenbarung der Erfindung

Die erfindungsgemäße Kühlvorrichtung mit den Merkmalen des Anspruchs 1 bietet demgegenüber den Vorteil einer verbesserten Kühlung von Bauteilen, wobei durch einen besonders zuverlässigen und robusten Aufbau eine Überhitzung der Bauteile sicher vermieden wird. Dies wird erfindungsgemäß erreicht durch eine Kühlvorrichtung umfassend eine Grundplatte, welche wärmeleitend mit einem zu kühlenden Bauteil verbindbar ist. Zudem weist die Kühlvorrichtung einen Umlenkbereich und einen Zwischenbereich auf, wobei der Zwischenbereich zwischen Umlenkbereich und Grundplatte angeordnet ist. Weiterhin umfasst die Kühlvorrichtung ein Kühlelement. Das Kühlelement ist mäanderförmig ausgebildet und weist mehrere Mittelsegmente und mehrere Umlenksegmente auf. Als mäanderförmig wird dabei insbesondere eine Form angesehen, welche mehrere Richtungswechsel, vorzugsweise in einer Ebene, aufweist. Beispielsweise kann mäanderförmig auch als schlangenförmig bezeichnet werden.

Die Mittelsegmente des Kühlelements erstrecken sich jeweils von der Grundplatte zum Umlenkbereich. Die Umlenksegmente bilden jeweils innerhalb der Grundplatte und innerhalb des Umlenkbereichs eine Richtungsumkehr. Jedes Umlenksegment verbindet jeweils zwei Mittelsegmente miteinander. Das heißt, das Kühlelement ist im Zwischenbereich angeordnet und erstreckt sich ausgehend von diesem bei jeder Richtungsumkehr in die Grundplatte bzw. in den Umlenkbereich hinein.

Die Grundplatte ist vorzugsweise aus Aluminium gebildet, um eine gute Wärmeleitung und thermische Anbindung des Bauteils und einen effektiven Wärmeabtransport von dem Bauteil zu ermöglichen. Weiter bevorzugt ist das Kühlelement ebenfalls aus Aluminium gebildet, um eine kostengünstige und thermisch gut leitende Verbindung, beispielweise eine Hartlötverbindung, mit der Grundplatte zu ermöglichen.

Weiterhin ist das Kühlelement mit einem Arbeitsmittel gefüllt, welches gleichzeitig gasförmig und flüssig, mit anderen Worten teils gasförmig und teils flüssig, in dem Kühlelement vorliegt. Das heißt, das Arbeitsmittel liegt im Kühlelement zweiphasig vor. Insbesondere liegen dabei innerhalb des Kühlelements Gasblasen sowie Flüssigkeitssäulen gleichzeitig vor. Vorzugsweise nehmen bei einer Nenntemperatur die Gasblasen sowie die Flüssigkeitssäulen ein ähnlich großes Volumen ein. Besonders bevorzugt nimmt der gasförmige Anteil des Arbeitsmittels bei der Nenntemperatur 30 % bis 70 % eines Innenvolumens des Kühlelements ein, wobei das restliche Innenvolumen durch den flüssigen Anteil des Arbeitsmittels eingenommen wird. In Abhängigkeit einer Temperatur der Kühlvorrichtung ändert sich dabei das Volumenverhältnis durch Verdampfen oder Kondensieren des Arbeitsmittels.

Vorzugsweise ist das Kühlelement rohrförmig ausgebildet. Bevorzugt ist das Kühlelement geschlossen ausgebildet. Hierfür weist das Kühlelement vorzugsweise einen Verbindungsbereich auf, welcher sich vorzugsweise innerhalb des Umlenkbereichs befindet, und welcher einen geschlossenen Kreislauf des Kühlelements bildet. Weiter bevorzugt weist das Kühlelement ein Ventil auf, um beispielsweise eine Evakuierung des Kühlelements und eine Befüllung des Kühlelements mit dem Arbeitsmittel zu ermöglichen.

Die Mittelsegmente weisen eine Vielzahl an Kanälen auf, vorzugsweise mindestens 4, bevorzugt mindestens 8, besonders bevorzugt mindestens 20. Innerhalb der Kanäle befindet sich jeweils das Arbeitsmittel. Jeder Kanal bildet dabei vorzugsweise eine Kavität, in welcher das Arbeitsmittel aufgenommen ist. Die Kanäle sind vorzugsweise parallel zueinander und nebeneinander angeordnet wird. Insbesondere sind die Kanäle entlang einer Richtung, welche senkrecht zu der Ebene, in welcher das Kühlelement mäanderförmig ausgebildet ist, angeordnet.

Bei einer Wärmezufuhr an die Grundplatte, das heißt, wenn sich das daran angrenzende Bauteil erwärmt, wird die Wärme von der Grundplatte auf das Kühlelement mit dem darin befindlichen Arbeitsmittel übertragen. Dadurch kann ein Phasenwechsel sowie eine Strömung des Arbeitsmittels innerhalb des Kühlelements erzeugt werden, wodurch die Wärme von der Grundplatte in Richtung Zwischenbereich transportiert wird. An einer Oberfläche des Kühlelements, insbesondere der Mittelbereiche, wird die Wärme durch Konvektion an die Umgebungsluft abgegeben. Insbesondere wird dadurch ein, insbesondere unregelmäßiger, pulsierender oder oszillierender Phasenübergang des Arbeitsmittels erzeugt. Ebenso liegt insbesondere eine pulsierende oder oszillierende Strömung des Arbeitsmittels im Kühlelement vor. Die Kühlvorrichtung arbeitet somit nach dem Prinzip eines pulsierenden Wärmerohres.

Durch die Vielzahl an Kanälen des Kühlelements kann dabei eine besonders gute Kühlwirkung erzielt werden. Vorteilhafterweise bildet hierbei jeder Kanal ein separates pulsierendes Wärmerohr. Insbesondere ist keine, beispielsweise elektrische, Energiezufuhr notwendig, sondern die Kühlvorrichtung arbeitet als passives Kühlelement. Somit bietet die Kühlvorrichtung eine besonders effektive Methode zur Kühlung der Leistungselektronik und kann Abwärme im Bereich mehrerer Kilowatt abführen.

Die Unteransprüche haben bevorzugte Weiterbildungen der Erfindung zum Inhalt.

Vorzugsweise sind die Mittelsegmente von Kühlrippen umgeben. Besonders bevorzugt ist ein gesamtes freies Volumen des Zwischenbereichs von den Kühlrippen ausgefüllt. Insbesondere sind dabei alle freien Bereiche zwischen den mäanderförmigen Windungen des Kühlelements durch die Kühlrippen ausgefüllt. Die Kühlrippen können dabei eine beliebige Geometrie aufweisen. Besonders einfach und kostengünstige sind beispielsweise gerade, plattenförmige Kühlrippen. Alternativ oder zusätzlich weisen die Kühlrippen vorzugsweise einen wellenförmigen, insbesondere sinuswellenförmigen, Querschnitt auf. Besonders bevorzugt sind die Kühlrippen alternativ oder zusätzlich in Form sogenannter Stegrippen (offset strip fins), Kiemenrippen (louvered fins), tiefengewellter Rippen, oder glatter Rippen ausgebildet. Für eine einfache und kostengünstige Herstellung und eine thermisch gut leitende Anbindung sind die Kühlrippen vorzugsweise aus Aluminium gebildet, und insbesondere mittels einer Hartlötverbindung mit dem Kühlelement verbunden.

Erfindungsgemäß ist das Kühlelement einstückig als mäanderförmig gebogenes Mehrkanalrohr ausgebildet. Insbesondere erstrecken sich somit die Kanäle jeweils über die gesamte Länge des Kühlelements. Vorzugsweise sind die Umlenksegmente U-förmig ausgebildet und weisen einen vordefinierten Biegeradius auf. Insbesondere kann der Biegeradius einen Mindestwert aufweisen, welcher beispielsweise abhängig von einer Fertigung des Mehrkanalrohrs ist. Dadurch ergibt sich ein besonders einfach und kostengünstig herzustellendes Kühlelement, welches eine effektive Wärmeabfuhr von der Grundplatte ermöglicht. Für eine besonders einfache Herstellbarkeit können die Mittelsegmente parallel zueinander ausgebildet sein.

Besonders bevorzugt grenzen die innerhalb der Grundplatte und/oder innerhalb des Umlenkbereichs angeordneten Umlenksegmente unmittelbar aneinander an. Vorzugsweise berühren sich somit die Umlenksegmente, insbesondere an deren Außenradius. Mit anderen Worten sind die Umlenksegmente möglichst dicht gepackt, um bei geringem Platzbedarf eine möglichst hohe Anzahl an Umlenksegmenten in der Grundplatte unterzubringen, für eine besonders hohe Kühlleistung pro Fläche. Beispielsweise können die Mittelsegmente dabei gegeneinander geneigt oder gebogen sein, um die enge Anordnung der Umlenksegmente zu ermöglichen.

Vorzugsweise weisen die umlenkbereichs-seitigen Umlenksegmente einen größeren Biegeradius als die grundplatten-seitigen Umlenksegmente auf.

Alternativ oder zusätzlich ist ein seitlicher Abstand zwischen den Mittelsegmenten zumindest abschnittsweise vergrößert. Dadurch wird ein für die Kühlrippen zur Verfügung stehendes Kühlvolumen, also insbesondere ein freies Volumen im Zwischenbereich, vergrößert, um eine besonders gute Wärmeabfuhr, und damit eine hohe Kühlleistung zu erzielen.

Weiter bevorzugt weist die Grundplatte jeweils eine Nut pro Umlenksegment auf. Jedes grundplatten-seitige Umlenksegment ist dabei in jeweils einer Nut angeordnet. Insbesondere ist dabei ein Radius der Nut an einen Außenradius des Umlenksegments eingepasst, um eine möglichst große Kontaktfläche bereitzustellen. Vorzugsweise sind das Kühlelement und die Grundplatte dabei im Bereich der Nut mittels einer stoffschlüssigen Verbindung miteinander verbunden. Die stoffschlüssige Verbindung ist vorzugsweise eine Hartlötverbindung. Dadurch wird eine besonders einfache und kostengünstige Herstellbarkeit der Kühlvorrichtung und ein gut wärmeleitender Kontakt zwischen Platte und Kühlelement sichergestellt.

Bevorzugt weist die Grundplatte jeweils ein Einlegeteil pro Nut auf. Das Einlegeteil ist an einer Innenseite, insbesondere an einem Innenradius des Umlenksegments angeordnet, und kann insbesondere so ausgebildet sein, dass es eine bündige Anordnung mit der Grundplatte bildet. Vorzugsweise weist das Einlegeteil dabei einen Querschnitt in Form eines Kreissegments auf. Besonders bevorzugt sind Einlegeteil und Umlenksegment und/oder Grundplatte mittels einer stoffschlüssigen Verbindung, vorzugsweise einer Hartlötverbindung, miteinander verbunden. Dadurch ergibt sich eine besonders hohe zur Wärmeübertragung verfügbare Fläche. Das Einlegeteil ist vorzugsweise aus Aluminium gebildet. Einlegeteil und Grundplatte können bevorzugt aus einer identischen Aluminium-Legierung, oder alternativ aus unterschiedlichen Aluminium-Legierungen, gebildet sein.

Vorzugsweise ist das Kühlelement mehrteilig ausgebildet. Dabei ist jedes Mittelsegment als, insbesondere gerades, Rohrstück ausgebildet, welches die Grundplatte und den Umlenkbereich miteinander verbindet. Vorzugsweise sind sämtliche Mittelsegmente identisch ausgebildet, um eine besonders einfache und kostengünstige Herstellung der Kühlvorrichtung zu ermöglichen. Beispielsweise können die Mittelsegmente jeweils mittels einer Hartlötverbindung mit der Grundplatte und mit dem, insbesondere als Platte ausgebildeten, Umlenkbereich verbunden sein. Bevorzugt sind die Mittelsegmente jeweils als gerade Mehrkanal-Rohrstücke ausgebildet, welche insbesondere parallel zueinander angeordnet sind. Besonders vorteilhaft ist es, wenn die Umlenksegmente jeweils als Kanal innerhalb der Grundplatte und/oder innerhalb des, insbesondere plattenförmigen, Umlenkbereichs ausgebildet sind. Vorzugsweise sind die Mittelsegmente dabei teilweise in den jeweiligen Umlenkbereich eingesteckt, um in diesen zu münden. Eine derartige Konstruktion erlaubt beispielsweise eine rechtwinklige Anordnung der Mittelsegmente und der Umlenksegmente relativ zueinander. Dadurch ist es nicht erforderlich, einen minimalen Biegeradius einzuhalten, wodurch die Mittelsegmente enger angeordnet werden können. Insbesondere kann dadurch bei gleicher vordefinierter Breite der Kühlvorrichtung eine höhere Anzahl an Mittelsegmenten vorgesehen sein, wodurch eine besonders effektive Kühlung möglich ist.

Besonders bevorzugt weist jedes Umlenksegment einen einzigen Umlenkkanal auf, in welchen sämtliche Kanäle der beiden durch das entsprechende Umlenksegment verbundenen Mittelsegmente münden. Das heißt, der Umlenkkanal ist als eine Kavität ausgebildet, in welche jeweils sämtliche Kanäle der angrenzenden Mittelsegmente münden. Besonders bevorzugt ist der Umlenkbereich dabei plattenförmig ausgebildet, insbesondere identisch zur Grundplatte. Grundplatte und Umlenkbereich sind vorzugsweise jeweils zweiteilig, als zwei aneinandergefügte Platten ausgebildet. Vorzugsweise weist eine erste Platte dabei jeweils eine Durchgangsöffnung pro Mittelsegment auf, durch welche das Mittelsegment durchgesteckt ist. Eine zweite Platte kann vorzugsweise eine Vertiefung, beispielsweise eine Nut oder ein Sackloch, aufweisen, welche die Kavität bilden, in die die Kanäle des Mittelsegments münden. Hierbei bilden zwei nebeneinanderliegende Durchgangsöffnungen und die die beiden Durchgangsöffnungen verbindende Vertiefung jeweils ein Umlenksegment. Dadurch ergibt sich eine besonders einfache und kostengünstige Herstellbarkeit der Kühlvorrichtung, wobei bei geringen Abmessungen eine besonders hohe Anzahl an Mittelsegmenten bereitgestellt werden kann.

Weiter bevorzugt weist jedes Umlenksegment eine Vielzahl an Umlenkkanälen auf. Jeder Umlenkkanal verbindet dabei zwei Kanäle der beiden durch das jeweilige Umlenksegment verbundenen Mittelsegmente miteinander. Somit erstreckt sich jeder Kanal des Kühlelements vorzugsweise durch das gesamte Kühlelement, wobei jeder Kanal jeweils eine separate, insbesondere geschlossene, Kavität bildet. Bevorzugt sind Umlenkbereich und Grundplatte dabei, insbesondere wie im vorhergehenden Absatz beschrieben, jeweils als zweiteilige Platte ausgebildet, wobei das Umlenksegment als Kombination aus zwei Durchgangsöffnungen in einer ersten Platte und einer Vertiefung in einer zweiten Platte ausgebildet ist. Die Vertiefung kann dabei mehrere Trennwände aufweisen, sodass beispielsweise mehrere parallele Nuten vorliegen, um die Vielzahl an Kanälen zu bilden. Dadurch wird das in den jeweiligen Kanälen befindlichen Arbeitsmittel jeweils in den entsprechenden Kanälen gehalten und ein unerwünschter Druckausgleich verhindert.

Besonders bevorzugt weist das Arbeitsmittel eine kritische Temperatur auf, die größer als eine maximale Betriebstemperatur ist. Vorzugsweise weist das Arbeitsmittel eine kritische Temperatur von mindestens 233 K, vorzugsweise mindestens 273 K besonders vorzugsweise mindestens 373 K, und insbesondere maximal 533 K, auf. Als kritische Temperatur wird dabei eine Temperatur eines Stoffes am kritischen Punkt angesehen. Dadurch wird sichergestellt, dass das Arbeitsmittel in einem bevorzugten Betriebsbereich, in welchem das Arbeitsmittel insbesondere bei Temperaturen von 222 K bis 473k, insbesondere von 273 K bis 373 K, vorliegt, zweiphasig innerhalb des Kühlelements vorliegen kann. Vorzugsweise ist das Arbeitsmittel ein organisches Kältemittel, welches beispielsweise in Fahrzeugklimaanlagen eingesetzt wird, wie insbesondere 2,3,3,3-Tetrafluorpropen, auch als R1234yf bezeichnet, R1233zd(E) usw.. Besonders bevorzugt weist das Arbeitsmittel einen Schmelzpunkt auf, welcher maximal 273 K, vorzugsweise maximal 233K, besonders bevorzugt maximal 213 K, beträgt.

Bevorzugt umfasst die Kühlvorrichtung ferner ein Gebläse, welches eingerichtet ist, eine Kühlluftströmung zu erzeugen. Das Gebläse ist dabei so angeordnet, dass die erzeugte Kühlluftströmung auf die Kühlrippen gerichtet ist, das heißt, entlang der Kühlrippen verläuft. Dadurch erfolgt ein besonders effektiver Wärmeabtransport von den Kühlrippen mittels erzwungener Konvektion.

Vorteilhafterweise ist die Kühlluftströmung dabei senkrecht zu der Ebene, in welcher die Mäanderform des Kühlelements definiert ist.

Vorzugsweise sind die Kühlrippen so ausgebildet, dass eine Kühlrippenoberfläche in Strömungsrichtung der Kühlluftströmung zunimmt. Besonders bevorzugt nimmt die Kühlrippenoberfläche linear zu, um eine bei der Durchströmung der Kühlluft durch den Zwischenbereich zunehmende Lufttemperatur zu kompensieren. Dadurch kann auch bei einer großen Anzahl an Kanälen des Mittelsegments, das heißt bei einer größeren Längserstreckung, eine effektive Kühlung erfolgen. Beispielsweise kann die Erhöhung der Kühlrippenoberfläche durch eine in der Strömungsrichtung erhöhte Kühlrippendichte, insbesondere durch eine zunehmende Anzahl an Kühlrippen pro Querschnittsfläche, erfolgen.

Weiter bevorzugt umfasst die Kühlvorrichtung eine Luftleitvorrichtung, welche zwischen Zwischenbereich und Umlenkbereich angeordnet ist. Die Luftleitvorrichtung ist so ausgebildet, um die Kühlluftströmung in den Zwischenbereich zu leiten. Beispielsweise ist die Luftleitvorrichtung dabei als Blech ausgebildet. Dadurch wird sichergestellt, dass die Kühlluftströmung vollständig in den Zwischenbereich geleitet wird, um dort durch erzwungene Konvektion die Wärme von den Kühlrippen abzuführen. Insbesondere wird durch die Luftleitvorrichtung eine Abschirmung eines nicht zur Kühlung beitragenden Bereichs der Kühlvorrichtung erzielt.

Weiterhin führt die Erfindung zu einer Elektronikanordnung, welche die beschriebene Kühlvorrichtung umfasst. Ferner umfasst die Elektronikanordnung ein zu kühlendes Bauteil, welches insbesondere ein Halbleiterbauteil, beispielsweise eines Kraftfahrzeugs, ist. Das zu kühlende Bauteil ist mit einer Grundplatte der Kühlvorrichtung wärmeleitend verbunden. Die Kühlvorrichtung ermöglicht dabei eine besonders effektive und zuverlässige Kühlung des Bauteils, um eine Überhitzung zu vermeiden.

### Kurze Beschreibung der Zeichnungen

Im Folgenden wird die Erfindung anhand von Ausführungsbeispielen in Verbindung mit den Figuren beschrieben. In den Figuren sind funktional gleiche Bauteile jeweils mit gleichen Bezugszeichen gekennzeichnet. Dabei zeigt:
- Figur 1: eine vereinfachte schematische Ansicht Elektronikanordnung mit einer Kühlvorrichtung gemäß einem ersten Ausführungsbeispiel der Erfindung,
- Figur 2: ein Detail der Kühlvorrichtung der Figur 1,
- Figur 3: eine vereinfachte schematische Ansicht einer Kühlvorrichtung gemäß einem zweiten Ausführungsbeispiel der Erfindung,
- Figur 4: eine vereinfachte schematische Ansicht einer Kühlvorrichtung gemäß einem dritten Ausführungsbeispiel der Erfindung,
- Figur 5: eine vereinfachte schematische Ansicht einer Kühlvorrichtung gemäß einem vierten Ausführungsbeispiel der Erfindung,
- Figur 6: eine vereinfachte schematische Ansicht einer Kühlvorrichtung gemäß einem fünften Ausführungsbeispiel der Erfindung,
- Figur 7: ein Detail der Kühlvorrichtung der Figur 6,
- Figur 8: ein Detail einer Kühlvorrichtung gemäß einem sechsten Ausführungsbeispiel der Erfindung, und
- Figur 9: vereinfachte schematische Detailansichten einer Kühlvorrichtung gemäß einem siebten Ausführungsbeispiel der Erfindung.

### Bevorzugte Ausführungsformen der Erfindung

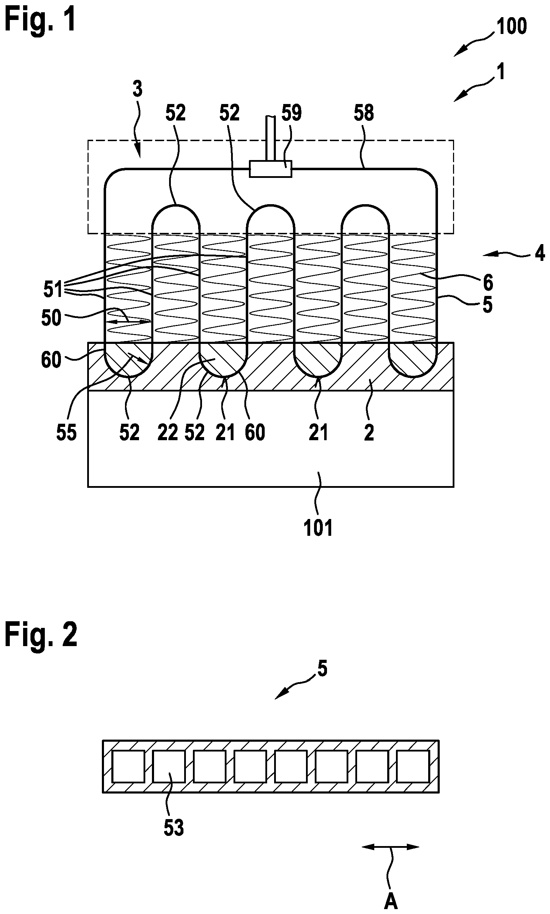

Die Figur 1 zeigt eine vereinfachte schematische Ansicht einer erfindungsgemäßen Elektronikanordnung 100. Die Elektronikanordnung 100 umfasst ein Halbleiterbauteil 101 mit einer Leistungselektronik und eine Kühlvorrichtung 1 gemäß einem ersten Ausführungsbeispiel der Erfindung. Die Kühlvorrichtung 1 ist dabei ausgebildet, um das Halbleiterbauteil 101 zu kühlen. Hierfür ist eine Grundplatte 2, welche aus Aluminium gebildet ist, wärmeleitend mit dem Halbleiterbauteil 101 verbunden.

Die Kühlvorrichtung 1 umfasst ein Kühlelement 5, welches mäanderförmig ausgebildet ist und mehrere Mittelsegmente 51 sowie mehrere Umlenksegmente 52 aufweist. Das Kühlelement 5 ist dabei einstückig als mäanderförmig gebogenes Mehrkanalrohr ausgebildet.

Die Figur 2 zeigt ein Detail der Figur 1, nämlich eine Schnittansicht des Kühlelements 5. Wie in der Figur 2 zu erkennen, besitzt das Kühlelement 5 einen flachen rechteckigen Querschnitt und weist insgesamt acht voneinander getrennte Kanäle 53 auf, welche nebeneinander entlang einer Längsrichtung A angeordnet sind. Es sei angemerkt, dass alternativ eine beliebige Anzahl an Kanälen 53 möglich ist. Die Längsrichtung A ist in der Figur 1 senkrecht zur Zeichenebene. Die Kanäle 53 weisen jeweils einen quadratischen Querschnitt, insbesondere mit einer Kantenlänge von 0,001 m, auf. Die Kanäle 53 erstrecken sich jeweils durch das gesamte Kühlelement 5 und bilden voneinander separate Kavitäten.

Wie in Figur 1 zu erkennen, erstreckt sich das Kühlelement 5 von der Grundplatte 2 nach oben durch einen Zwischenbereich 4 bis hin zu einem Umlenkbereich 3. Zwischenbereich 4 und Umlenkbereich 3 sind dabei vorzugsweise luftgefüllt. Die Mittelsegmente 51 erstrecken sich jeweils von der Grundplatte 2 zum Umlenkbereich 3, also durch den Zwischenbereich 4 hindurch. Dabei sind alle Mittelsegmente 51 gerade ausgebildet und parallel zueinander angeordnet. Die Umlenksegmente 52 sind jeweils an den Enden der Mittelsegmente 51 innerhalb des Umlenkbereichs 3 sowie innerhalb der Grundplatte 2 angeordnet und bilden jeweils eine Richtungsumkehr. Dabei verbindet jeweils ein Umlenksegment 52 zwei Mittelsegmente 51 miteinander.

Die Umlenksegmente 52 sind jeweils U-förmig ausgebildet und weisen einen Biegeradius 55 auf. Dadurch sind die Mittelsegmente 51 in einem Abstand 50, welcher dem doppelten Biegeradius 55 entspricht, zueinander angeordnet. Grundplatten-seitig sind die Umlenksegmente 52 jeweils in einer Nut 21 angeordnet, sodass ein flächiger Kontakt der Umlenksegmente 52 mit der Grundplatte 2 jeweils an einer Außenseite der Umlenksegment 52 vorliegt.

An einer Innenseite der Umlenksegmente 52 befinden sich jeweils kreissegmentförmige Einlegeteile 22, welche eine bündige Anordnung mit der Grundplatte 2 bilden. Dadurch kann die Wärme besonders mit besonders geringer Temperaturdifferenz und gleichmäßig auf das Kühlelement 5 übertragen werden.

Um eine feste Verbindung und einen guten Wärmetransport von der Grundplatte 2 an das Kühlelement 5 zu ermöglichen, sind die Umlenksegmente 52, die Grundplatte 2 und die Einlegeteile 22 mittels Hartlötverbindungen 60 miteinander verbunden.

Weiterhin weist das Kühlelement 5 einen Verbindungsbereich 58 auf, welcher innerhalb des Umlenkbereichs 3 angeordnet ist, und welcher einen geschlossenen Kreislauf des Kühlelements 5 bereitstellt. Innerhalb des Verbindungsbereichs 58 ist ein Ventil 59 vorgesehen, welches in geschlossenem Zustand das Kühlelement 5 geschlossen hält, und in offenem Zustand eine Evakuierung und eine Befüllung der Kanäle 53 des Kühlelements 5 erlaubt.

Innerhalb der Kanäle 53 des Kühlelements 5 befindet sich ein Arbeitsmittel, welches gleichzeitig in flüssigen und in gasförmigen Zustand vorliegt. Bei einer Erwärmung der Grundplatte 2 durch das Halbleiterbauteil 101 erfolgt eine Erwärmung des Kühlelements 5 sowie des darin befindlichen Arbeitsmittels. Durch eine Kombination aus Verdampfung, Kondensation, konvektivem Wärmetransport und Wärmeleitung erfolgt ein Abtransport der Wärme von der Grundplatte 2 und somit eine Kühlung des Halbleiterbauteils 101.

Ein Wärmeabtransport von dem Kühlelement 5 erfolgt dabei durch wärmeleitend mit den Mittelsegmenten 51 verbundenen Kühlrippen 6. Die Kühlrippen 6 sind dabei innerhalb des gesamten freien Volumens des Zwischenbereichs 4 zwischen den Mittelsegmenten 51 angeordnet. Die Kühlvorrichtung 1 arbeitet somit nach dem Prinzip eines pulsierenden Wärmerohres.

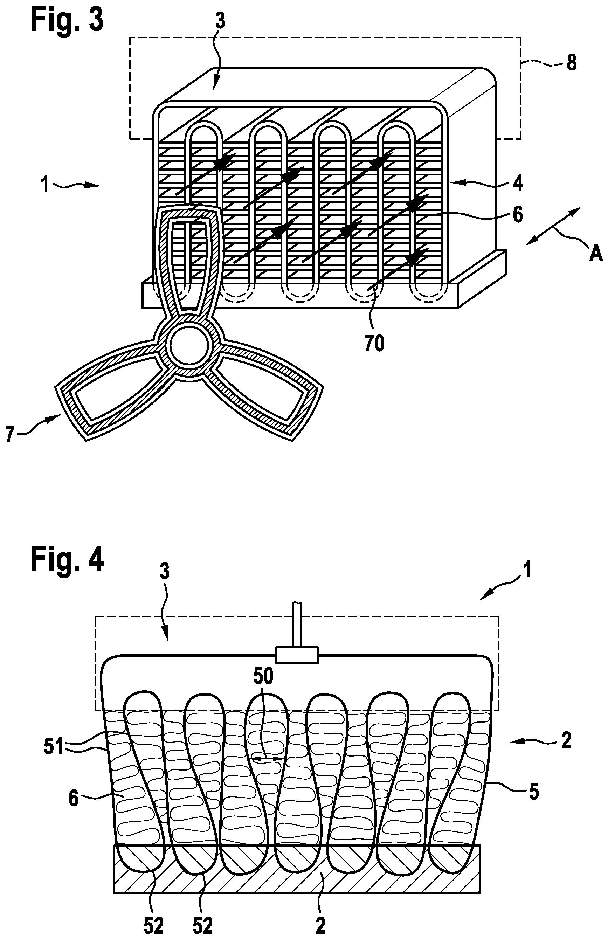

Die Figur 3 zeigt eine vereinfachte schematische Ansicht einer Kühlvorrichtung 1 gemäß einem zweiten Ausführungsbeispiel der Erfindung. Das zweite Ausführungsbeispiel entspricht im Wesentlichen dem ersten Ausführungsbeispiel der Figuren 1 und 2, wobei die Kühlvorrichtung 1 zusätzlich ein Gebläse 7 und eine Luftleitvorrichtung 8 aufweist. Zur besseren Anschaulichkeit der Kühlvorrichtung 1 ist die Luftleitvorrichtung 8 nur gestrichelt angedeutet.

Das Gebläse 7 erzeugt eine Kühlluftströmung, welche auf die Kühlrippen 6 gerichtet ist. Eine Strömungsrichtung 70 der Kühlluftströmung ist dabei parallel zur Längsrichtung A. Die Luftleitvorrichtung 8 ist als Blech ausgebildet und bewirkt, dass die Kühlluftströmung vollständig in den Zwischenbereich 4 geleitet wird, indem die Luftleitvorrichtung 8 den Umlenkbereich 3 abschirmt. Durch die Kühlluftströmung erfolgt somit mittels erzwungener Konvektion ein besonders guter Wärmeabtransport von den Kühlrippen 6, um eine besonders hohe Kühlleistung der Kühlvorrichtung 1 zu erhalten.

Die Figur 4 zeigt eine vereinfachte schematische Ansicht einer Kühlvorrichtung 1 gemäß einem dritten Ausführungsbeispiel der Erfindung. Das dritte Ausführungsbeispiel entspricht im Wesentlichen dem ersten Ausführungsbeispiel der Figuren 1 und 2 mit einer alternativen Anordnung des Kühlelements 5. Im dritten Ausführungsbeispiel der Figur 4 sind die Umlenksegmente 52 unmittelbar aneinander angrenzend angeordnet, sodass in der Grundplatte 2 eine größere Anzahl an Umlenksegmenten 52 Platz findet. Dadurch kann eine Kühlleistung der Kühlvorrichtung 1 pro Volumen erhöht werden. Um die dichter gepackte Anordnung der Umlenksegmente 52 zu ermöglichen, sind die Mittelsegmente 51 gebogen ausgebildet, sodass das Kühlelement 5 eine Geometrie mit mehreren hantelförmigen Schleifen aufweist.

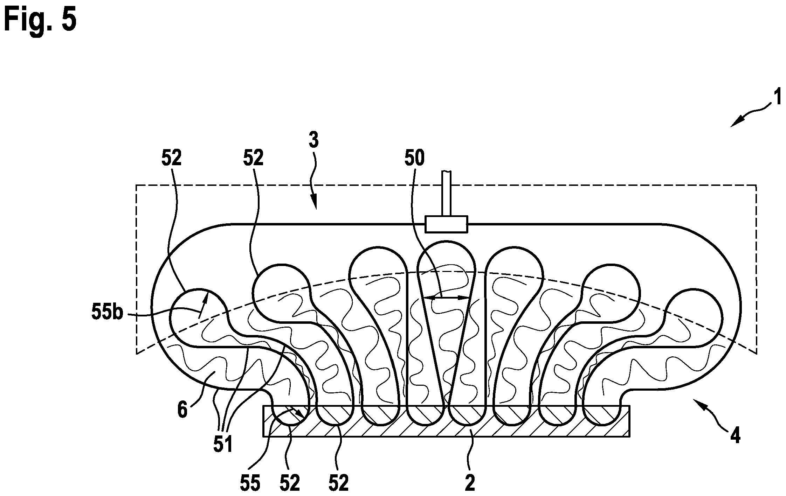

Die Figur 5 zeigt eine vereinfachte schematische Ansicht einer Kühlvorrichtung 1 gemäß einem vierten Ausführungsbeispiel der Erfindung. Das vierte Ausführungsbeispiel entspricht im Wesentlichen dem dritten Ausführungsbeispiel der Figur 4, wobei die umlenkbereichsseitigen Umlenksegmente 52 einen vergrößerten Biegeradius 55b im Vergleich zu den grundplattenseitigen Umlenksegmenten 52 aufweisen. Zudem ist der seitliche Abstand 50 zwischen den Mittelsegmenten 51 nahe des Umlenkbereichs 3 vergrößert. Um dies zu erreichen ist der Umlenkbereich 3 im Vergleich zur Grundplatte 2 verbreitet.

Diese Maßnahmen bieten somit ein größeres freies Volumen im Zwischenbereich 2, um mehr freien Raum für die Kühlrippen 6 zu bieten, sodass eine besonders hohe Kühlleistung erzielt werden kann.

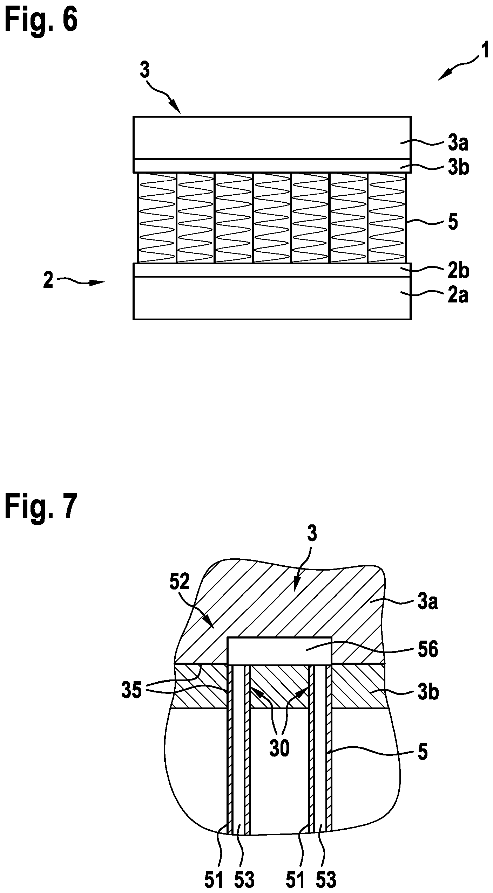

Die Figur 6 zeigt eine vereinfachte schematische Ansicht einer Kühlvorrichtung 1 gemäß einem fünften Ausführungsbeispiel der Erfindung. Die Figur 7 zeigt eine Detail-Schnittansicht der Figur 6. Das fünfte Ausführungsbeispiel entspricht im Wesentlichen dem ersten Ausführungsbeispiel der Figuren 1 und 2, mit einer alternativen Ausgestaltung des Kühlelements 5 und der Grundplatte 2 und des Umlenkbereichs 3. Im fünften Ausführungsbeispiel ist die Grundplatte 2 aus zwei Platten 2a, 2b zweiteilig ausgebildet. Eine ähnliche zweiteilige Konstruktion weist der Umlenkbereich 3 auf mit einer ersten Platte 3a und einer zweiten Platte 3b.

Zudem ist das Kühlelement 5 im fünften Ausführungsbeispiel mehrteilig ausgebildet. Dabei umfasst das Kühlelement 5 mehrere einzelne als Mehrkanalrohr ausgebildete gerade Mittelsegmente 51.

Der Aufbau des Kühlelements 5 ist beispielhaft anhand einer einzelnen Richtungsumkehr um Umlenkbereich 3 in der Figur 7 dargestellt. Die zweite Platte 3b weist dabei pro Mittelsegment 51 jeweils eine Durchgangsöffnung 30 auf, durch welche das Mittelsegment 51 durchgesteckt ist. Daran angrenzend ist innerhalb der ersten Platte 3a ein Umlenkkanal 56 in Form einer Nut ausgebildet. Der Umlenkkanal 56 verbindet die beiden nebeneinanderliegenden Mittelsegmente 51 miteinander. Der Umlenkkanal 56 bildet dabei die Richtungsumkehr des Umlenksegments 52. Zudem ist der Umlenkkanal 56 in Form einer einzigen Kavität ausgebildet, in welche sämtliche Kanäle 53 der jeweils angrenzenden Mittelsegmente 51 münden. Zur fluiddichten Verbindung, und um eine gute Wärmeleitung sicherzustellen, sind an den Kontaktflächen zwischen der ersten Platte 3a und der zweiten Platte 3b sowie zwischen den Mittelsegmenten 51 und der zweiten Platte 3b jeweils Hartlötverbindungen 35 vorgesehen.

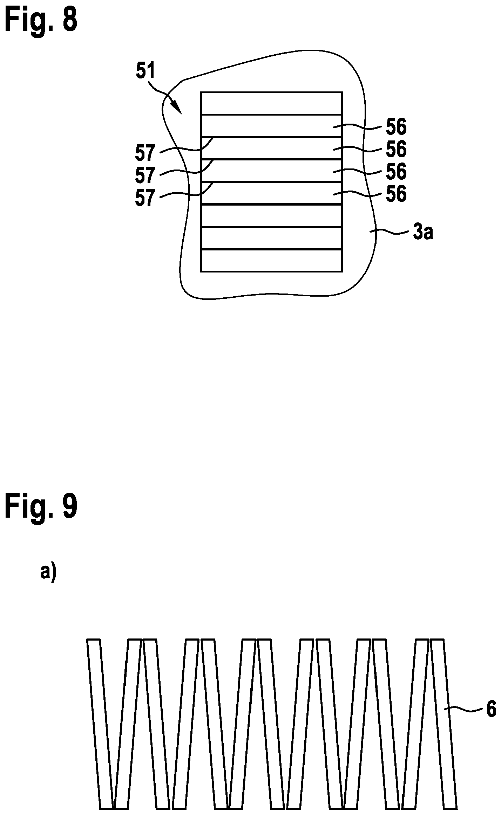

Die Figur 8 zeigt ein Detail einer Kühlvorrichtung 1 gemäß einem sechsten Ausführungsbeispiel der Erfindung. Das sechste Ausführungsbeispiel entspricht im Wesentlichen dem fünften Ausführungsbeispiel der Figuren 6 und 7, wobei das Umlenksegment 52 eine Vielzahl an Umlenkkanälen 56 aufweist anstatt eines einzelnen. Dargestellt ist in der Figur 8 dabei eine Draufsicht auf die erste Platte 3a, in welcher die mehreren Umlenkkanäle 56 jeweils als Nuten ausgebildet sind. Zwischen den einzelnen Umlenkkanälen 56 ist jeweils eine Trennwand 57 ausgebildet. Dadurch liegt pro Kanal 53 des Mittelsegments 51 jeweils genau ein Umlenkkanal 56 vor, sodass kein Austausch des Arbeitsmittels zwischen den einzelnen Kanälen 53 erfolgen kann.

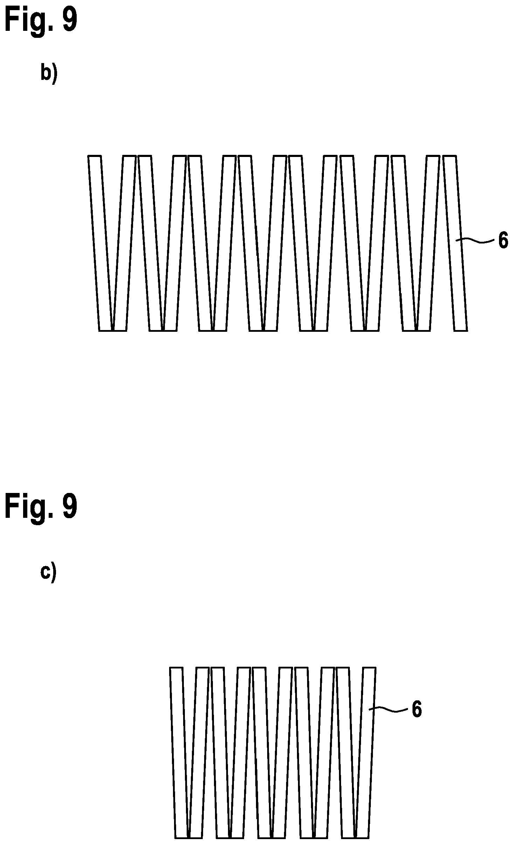

Die Figur 9 zeigt vereinfachte schematische Detailansichten einer Kühlvorrichtung 1 gemäß einem siebten Ausführungsbeispiel der Erfindung. Das siebte Ausführungsbeispiel entspricht im Wesentlichen dem zweiten Ausführungsbeispiel der Figur 3, mit einer alternativen Ausgestaltung der Kühlrippen 6. Dargestellt sind in der Figur 9 dabei drei Ansichten der Kühlrippen 6 in verschiedenen Schnittebenen entlang der Strömungsrichtung 70, welche insbesondere senkrecht zur Zeichenebene ist. Ansicht (a) zeigt dabei eine Draufsicht auf die Kühlrippen 6 in einer Eintrittsebene der Kühlluftströmung in den mit Kühlrippen 6 ausgefüllten Bereich der Kühlvorrichtung 1. Ansicht (b) zeigt die Kühlrippen 6 in einer Schnittebene in Strömungsrichtung 70 stromab der in Ansicht (a) dargestellten Geometrie und Ansicht (c) zeigt die Kühlrippen 6 in einer Schnittebene in Strömungsrichtung 70 stromab der in Ansicht (b) dargestellten Geometrie. Wie in der Figur 9 zu erkennen, nimmt dabei eine Kühlrippendichte pro Volumen in Strömungsrichtung 70 zu. Dadurch nimmt auch eine Kühlrippenoberfläche entlang der Strömungsrichtung 70 zu. Dadurch steigt in Strömungsrichtung 70 die für den konvektiven Wärmetransport zur Verfügung stehende Kühlrippenoberfläche. Hierdurch kann ein in Strömungsrichtung 70 zunehmendes Aufheizen der Kühlluftströmung durch die aufgenommene Wärme kompensiert werden, um einen besonders effektiven Wärmeabtransport über das gesamte Volumen der Kühlvorrichtung 1 zu erhalten.

## Patentansprüche

1. Kühlvorrichtung, zum Kühlen von Bauteilen (101) umfassend:
- eine Grundplatte (2), welche wärmeleitend mit einem zu kühlenden Bauteil (101) verbindbar ist,
- einen Umlenkbereich (3),
- einen Zwischenbereich (4) zwischen der Grundplatte (2) und dem Umlenkbereich (3), und
- ein Kühlelement (5), welches mäanderförmig ausgebildet ist und mehrere Mittelsegmente (51) und mehrere Umlenksegmente (52) aufweist,
- wobei sich die Mittelsegmente (51) jeweils von der Grundplatte (2) zum Umlenkbereich (3) erstrecken,
- wobei die Umlenksegmente (52) jeweils innerhalb der Grundplatte (2) und innerhalb des Umlenkbereichs (3) eine Richtungsumkehr bilden und jeweils zwei Mittelsegmente (51) miteinander verbinden,
- wobei das Kühlelement (5) mit einem Arbeitsmittel gefüllt ist, welches gleichzeitig gasförmig und flüssig in dem Kühlelement (5) vorliegt, und
- wobei die Mittelsegmente (51) eine Vielzahl an Kanälen (53) aufweisen, wobei das Kühlelement (5) einstückig als mäanderförmig gebogenes Mehrkanalrohr ausgebildet ist.

2. Kühlvorrichtung nach Anspruch 1, wobei die Mittelsegmente (51) von Kühlrippen (6) umgeben sind.

3. Kühlvorrichtung nach einem der vorhergehenden Ansprüche, wobei die Umlenksegmente (52) U-förmig ausgebildet sind und einen vordefinierten Biegeradius (55) aufweisen.

4. Kühlvorrichtung nach einem der vorhergehenden Ansprüche, wobei jeweils die innerhalb der Grundplatte (2) und/oder innerhalb des Umlenkbereichs (3) angeordneten Umlenksegmente (52) unmittelbar aneinander angrenzen.

5. Kühlvorrichtung nach einem der vorhergehenden Ansprüche, wobei die umlenkbereichs-seitigen Umlenksegmente (52) einen größeren Biegeradius (55) als die grundplatten-seitigen Umlenksegmente (52) aufweisen, und/oder wobei ein seitlicher Abstand (50) zwischen den Mittelsegmenten (51) zumindest abschnittsweise vergrößert ist, zum Vergrößern eines für die Kühlrippen (6) zur Verfügung stehenden Kühlvolumens.

6. Kühlvorrichtung nach einem der vorhergehenden Ansprüche, wobei die Grundplatte (2) jeweils eine Nut (21) pro Umlenksegment (52) aufweist, und wobei jedes grundplatten-seitige Umlenksegment (52) in jeweils einer Nut (21) angeordnet ist.

7. Kühlvorrichtung nach Anspruch 6, wobei die Grundplatte (2) jeweils ein Einlegeteil (22) pro Nut (21) aufweist, welches an einer Innenseite des Umlenksegments (52) angeordnet ist, und welches zur bündigen Anordnung mit der Grundplatte (2) ausgebildet ist.

8. Kühlvorrichtung nach einem der vorhergehenden Ansprüche, wobei das Arbeitsmittel eine kritische Temperatur von mindestens 333 K, bevorzugt mindestens 373 K, besonders bevorzugt mindestens 433 K, vorzugsweise maximal 473 K, aufweist.

9. Kühlvorrichtung nach einem der Ansprüche 2 bis 7, ferner umfassend ein Gebläse (7), welches eingerichtet ist, eine Kühlluftströmung zu erzeugen, wobei die Kühlluftströmung auf die Kühlrippen (6) gerichtet ist.

10. Kühlvorrichtung nach Anspruch 9, wobei die Kühlrippen (6) so ausgebildet sind, dass eine Kühlrippenoberfläche in Strömungsrichtung (70) der Kühlluftströmung zunimmt.

11. Kühlvorrichtung nach einem der Ansprüche 9 oder 10, ferner umfassend eine Luftleitvorrichtung (8), welche zwischen Zwischenbereich (4) und Umlenkbereich (3) angeordnet ist, und welche die Kühlluftströmung in den Zwischenbereich (4) leitet.

12. Elektronikanordnung, umfassend:
- ein Bauteil (101), insbesondere ein Halbleiterbauteil, und
- eine Kühlvorrichtung (1) nach einem der vorhergehenden Ansprüche,
- wobei das Bauteil (101) mit einer Grundplatte (2) der Kühlvorrichtung (1) wärmeleitend verbunden ist.

## Claims

1. Cooling device for cooling components (101), comprising:
- a baseplate (2) which can be connected in a heat-conducting manner to a component (101) to be cooled,
- a deflection region (3),
- an intermediate region (4) between the baseplate (2) and the deflection region (3), and
- a cooling element (5), which is of meandering design and has a plurality of central segments (51) and a plurality of deflection segments (52),
- wherein the central segments (51) each extend from the baseplate (2) to the deflection region (3),
- wherein the deflection segments (52) each create a reversal of direction within the baseplate (2) and within the deflection region (3) and connect two respective central segments (51) to one another,
- wherein the cooling element (5) is filled with a working medium which is present simultaneously in the gaseous and the liquid state in the cooling element (5), and
- wherein the central segments (51) have a multiplicity of channels (53), wherein the cooling element (5) is formed in one piece as a multichannel tube bent in a meandering shape.

2. Cooling device according to Claim 1, wherein the central segments (51) are surrounded by cooling fins (6).

3. Cooling device according to either of the preceding claims, wherein the deflection segments (52) are of U-shaped design and have a predefined bending radius (55).

4. Cooling device according to any of the preceding claims, wherein the deflection segments (52), which are arranged within the baseplate (2) and/or within the deflection region (3), are each directly adjacent to one another.

5. Cooling device according to any of the preceding claims, wherein the deflection segments (52) on the side of the deflection region have a larger bending radius (55) than the deflection segments (52) on the baseplate side, and/or wherein a lateral spacing (50) between the central segments (51) is increased, at least in some section or sections, in order to increase a cooling volume available for the cooling fins (6).

6. Cooling device according to any of the preceding claims, wherein the baseplate (2) has one groove (21) for each deflection segment (52), and wherein each deflection segment (52) on the baseplate side is arranged in a respective groove (21) .

7. Cooling device according to Claim 6, wherein the baseplate (2) has one insert (22) for each groove (21), which insert is arranged on an inner side of the deflection segment (52) and is designed for flush arrangement with the baseplate (2).

8. Cooling device according to any of the preceding claims, wherein the working medium has a critical temperature of at least 333 K, preferably at least 373 K, particularly preferably at least 433 K, preferably not more than 473 K.

9. Cooling device according to any of Claims 2 to 7, further comprising a fan (7) which is configured to generate a cooling air flow, wherein the cooling air flow is directed towards the cooling fins (6).

10. Cooling device according to Claim 9, wherein the cooling fins (6) are designed in such a way that a cooling fin surface area increases in the flow direction (70) of the cooling air flow.

11. Cooling device according to either of Claims 9 or 10, further comprising an air guiding device (8), which is arranged between the intermediate region (4) and the deflection region (3) and which guides the cooling air flow into the intermediate region (4).

12. Electronic assembly comprising:
- a component (101), in particular a semiconductor component, and
- a cooling device (1) according to any of the preceding claims,
- wherein the component (101) is connected in a heat-conducting manner to a baseplate (2) of the cooling device (1).

## Revendications

1. Dispositif de refroidissement destiné à refroidir des composants (101), ledit dispositif de refroidissement comprenant :
- une plaque de base (2) qui peut être reliée de manière thermoconductrice à un composant (101) à refroidir,
- une zone de déviation (3),
- une zone intermédiaire (4) entre la plaque de base (2) et la zone de déviation (3), et
- un élément de refroidissement (5) qui est conçu en forme de méandre et qui comporte plusieurs segments médians (51) et plusieurs segments de déviation (52),
- les segments médians (51) s'étendant chacun de la plaque de base (2) à la zone de déviation (3),
- les segments de déviation (52) formant chacun une inversion de sens à l'intérieur de la plaque de base (2) et à l'intérieur de la zone de déviation (3) et reliant chacun deux segments médians (51) l'un à l'autre,
- l'élément de refroidissement (5) étant rempli d'un agent de travail qui est présent simultanément sous forme gazeuse et sous forme liquide dans l'élément de refroidissement (5), et
- les segments médians (51) comportant un grand nombre de canaux (53), l'élément de refroidissement (5) étant conçu d'une seule pièce sous la forme d'un tube multicanal courbé en forme de méandres.

2. Dispositif de refroidissement selon la revendication 1, les segments médians (51) étant entourés d'ailettes de refroidissement (6).

3. Dispositif de refroidissement selon l'une des revendications précédentes, les segments de déviation (52) étant en forme de U et ayant un rayon de courbure (55) prédéfini.

4. Dispositif de refroidissement selon l'une des revendications précédentes, les segments de déviation (52) disposés à l'intérieur de la plaque de base (2) et/ou à l'intérieur de la zone de déviation (3) étant directement adjacents les uns aux autres.

5. Dispositif de refroidissement selon l'une des revendications précédentes, les segments de déviation (52) côté zone de déviation ayant un rayon de courbure (55) plus grand que les segments de déviation (52) côté plaque de base, et/ou une distance latérale (50) entre les segments médians (51) étant augmentée au moins par portions afin d'augmenter le volume de refroidissement disponible pour les ailettes de refroidissement (6).

6. Dispositif de refroidissement selon l'une des revendications précédentes, la plaque de base (2) comportant une rainure (21) par segment de déviation (52), et chaque segment de déviation côté plaque de base (52) étant disposé dans une rainure respective (21) .

7. Dispositif de refroidissement selon la revendication 6, la plaque de base (2) comportant un insert (22) par rainure (21) qui est disposé sur un côté intérieur du segment de déviation (52), et qui est conçu pour être disposé à fleur de la plaque de base (2) .

8. Dispositif de refroidissement selon l'une des revendications précédentes, l'agent de travail ayant une température critique d'au moins 333 K, de préférence d'au moins 373 K, de manière particulièrement préférée d'au moins 433 K, de préférence de 473 K maximum.

9. Dispositif de refroidissement selon l'une des revendications 2 à 7, comprenant en outre une soufflante (7) qui est conçue pour générer un écoulement d'air de refroidissement, l'écoulement d'air de refroidissement étant dirigé vers les ailettes de refroidissement (6).

10. Dispositif de refroidissement selon la revendication 9, les ailettes de refroidissement (6) étant conçues de telle sorte qu'une surface d'ailette de refroidissement augmente dans le sens d'écoulement (70) de l'écoulement d'air de refroidissement.

11. Dispositif de refroidissement selon l'une des revendications 9 ou 10, comprenant en outre un dispositif de guidage d'air (8) qui est disposé entre la zone intermédiaire (4) et la zone de déviation (3) et qui dirige l'écoulement d'air de refroidissement jusque dans la zone intermédiaire (4).

12. Ensemble électronique, comprenant :
- un composant (101), notamment un composant semiconducteur, et
- un dispositif de refroidissement (1) selon l'une des revendications précédentes,
- le composant (101) étant relié de manière thermoconductrice à une plaque de base (2) du dispositif de refroidissement (1).
